# EUROPEAN PATENT APPLICATION

(11) **EP 1 612 574 A1**
(43) Date of publication of application: **04.01.2006**
(21) Application number: 04725993.2
(22) Date of filing: 06.04.2004
(51) Int. Cl.: G01R 33/02

(54) **MAGNETIC SENSOR INTEGRATED WITH CONTROLLING DEVICE**

(30) Priority: 25.04.2003 JP 2003122387
(71) Applicant: HST CO., LTD., Tokyo 144-8587 (JP)
(72) Inventor: ABE, Masanori, c/o HST Co.,Ltd., Yokohama-shi, Kanagawa 222-0033 (JP); GOTO, Akihiro, c/o HST Co., Ltd., Yokohama-shi, Kanagawa 222-0033 (JP); OYAMA, Shoji, c/o HST Co., Ltd., Yokohama-shi, Kanagawa 222-0033 (JP); ABE, Masaaki, c/o HST Co., Ltd., Yokohama-shi, Kanagawa 222-0033 (JP); BABA, Yasuhisa, Atsugi-shi, Kanagawa 2430032 (JP); KURIHARA, Yukio, Atsugi-shi, Kanagawa 2430031 (JP); NEGISHI, Kiyoshi, Yokosuka-shi, Kanagawa 2390808 (JP); HOSHIKAWA, Kiyoshi, Yokohama-shi, Kanagawa 2350023 (JP); ABE, Susumu, Yokohama-shi, Kanagawa 221-0801 (JP)
(74) Representative: Müller-Boré & Partner Patentanwälte
(86) International application number: PCT/JP2004/004964
(87) International publication number: WO 2004/097441

(57) **Abstract**

A magnetically sensitive element is integrated with an operation controlling element by film-forming process or bonding of film-shaped bodies. The operation controlling element is formed as a single layer or multilayers and contains a permanent magnet or a magnetic circuit forming member. A pickup coil may also be integrated thereto. The magnetically sensitive element is a magnetic element in which a giant Barkhausen jump phenomenon appears.

## Description

### Technical Field

The present invention relates to a magnetically sensitive element such as a magnetic element in which a giant Barkhausen Jump phenomenon appears.

### Background Art

Magnetically sensitive elements such as magnetic elements in which giant Barkhausen Jump phenomena appear are used along with associated control devices for controlling the operation of the magnetically sensitive elements, and the magnetic element-and-control combinations are used in a variety of machines and apparatuses. In addition to the particular magnetic element in which a giant Barkhausen Jump phenomenon appears such magnetically sensitive elements include Hall devices; MR elements (magneto-resistive elements); GMR elements (giant magneto-resistance elements); TMR elements (tunneling magneto-resistive elements) and so on. Particularly magnetic elements in which a giant Barkhausen Jump phenomenon appears have been widely used in pulse generators, measuring devices, detectors markers and such like these days.

When applied to these apparatuses, a magnetically sensitive element and an associated control unit are separately made and adjusted, and then these products are joined together, fixedly arranged on a substrate or base plate, and finally adjusted.

One of such prior art magnetically sensitive devices is disclosed in Laid-Open Patent Application No.2000-30939.

Disadvantageously the conventional method of making such magnetically sensitive elements involves arranging, connecting and fixing the separate elements onto a substrate. A variety of parts and tools such as brackets, jigs and soldering and bonding tools need to be used, and still disadvantageously the required precise adjustment for absolute/relative positioning of parts is a very difficult, laborious work. Accordingly the manufacturing cost is high, and the quality of these products varies widely. Still disadvantageously, improvement in precision and stability, and reduction in size are restricted to certain limits.

The object of the present invention is to provide a magnetically sensitive element with an operation controlling element integrated therewith and with or without a pickup coil or coils integrated therewith, thus guaranteed to be free of the defects as described above,.

### Disclosure of the Invention

According to one aspect of the present invention there is provided a magnetically sensitive element characterized in that it is integrated with an operation controlling element.

According to one embodiment of the present invention the magnetically sensitive element and the operation controlling element are integrally connected according to the film-forming process.

According to another embodiment of the present invention the magnetically sensitive element and the operation controlling element are integrally connected by sticking pieces of films or thin layers on each other.

According to still another embodiment of the present invention the operation controlling element is given in the form of a single layer.

According to still another embodiment of the present invention the operation controlling element is given in the form of plural layers.

According to still another embodiment of the present invention the operation controlling element comprises a permanent magnet.

According to still another embodiment of the present invention the operation controlling element comprises an electromagnet.

According to still another embodiment of the present invention the operation controlling element includes a magnetic circuit forming member.

According to still another embodiment of the present invention the magnetically sensitive element is a magnetic element in which a giant Barkhausen Jump phenomenon appears.

According to still another embodiment of the present invention the magnetically sensitive element is integrated with a pickup coil or coils.

Preferred embodiments of the present invention will be described below with reference to the accompanying drawings.

### Brief Description of Drawings

Fig.1 is a perspective view of a magnetically sensitive element with an associated operation controlling element integrated therewith according to the first embodiment of the present invention;
Fig.2 is a perspective view of a magnetically sensitive element with an associated operation controlling element integrated therewith according to the second embodiment of the present invention;
Fig.3 is a perspective view of a magnetically sensitive element with an associated operation controlling element integrated therewith according to the third embodiment of the present invention;
Fig.4 is a perspective view of a magnetically sensitive element with an associated operation controlling element integrated therewith according to the fourth embodiment of the present invention;
Fig.5 is a perspective view of a magnetically sensitive element with an associated operation controlling element integrated therewith according to the fifth embodiment of the present invention;
Fig.6 is a perspective view of a magnetically sensitive element with an associated operation controlling element integrated therewith according to the sixth embodiment of the present invention;
Fig.7 is a perspective view of a magnetically sensitive element with an associated operation controlling element and pickup coils integrated therewith according to the seventh embodiment of the present invention;
Fig.8 is a plane view of the seventh embodiment of the present invention;
Fig.9 is a perspective view of a magnetically sensitive element with an associated operation controlling element integrated therewith according to the eighth embodiment of the present invention; and
Fig.10 is a perspective view of a magnetically sensitive element with an associated operation controlling element integrated therewith according to the ninth embodiment of the present invention.

### Preferred Embodiments of the Present Invention

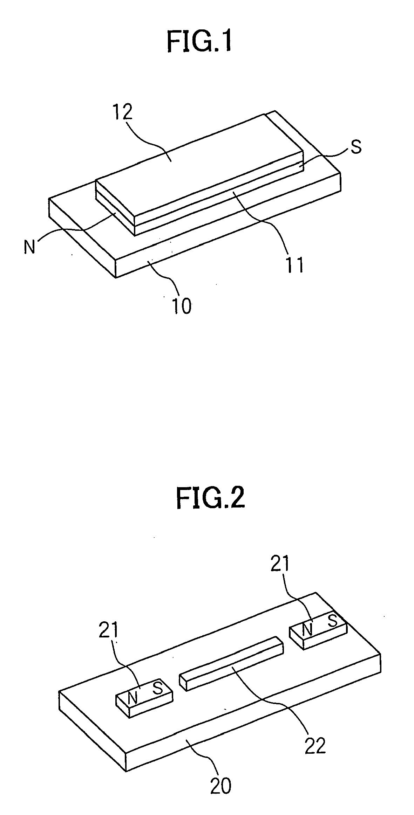

Fig.1 shows a magnetically sensitive element with an associated operation controlling element integrated therewith according to the first embodiment of the present invention. It comprises a substrate 10 having the operation controlling element 11 and the magnetically sensitive element 12 both integrally formed thereon. The substrate 10 is of a material permitting thin film layers to be formed thereon, not only a solid material such as silicon or glass but also a flexible material and even a liquid. The substrate 10 may be a variety of laminated structures such as a flip chip bonding. The magnetically sensitive element 12 may be a giant Barkhausen element, a Hall element, an MR element, a GMR element or a TMR element. The operation controlling element 11 generally means an object which can apply a magnetic field to the magnetically sensitive element 12, such as a permanent magnet or an electromagnet, and may include an associated magnetic circuit which is positioned so close to the magnetically sensitive element 12 that it may lead the magnetic flux from the magnet toward the magnetically sensitive element 12. The operation controlling element 11 is an element to create a magnetic field having an influence over the magnetically sensitive element 12.

In the first embodiment the operation controlling element 11 and the magnetically sensitive element 12 are so integrally connected according to the thin-film forming process that the operation controlling element 11 is laid on the substrate 10, and that the magnetically sensitive element 12 is laid on the operation controlling element 11.

When occasions demand, there may be an intervening insulation or non-magnetic layer between the substrate 10 and the overlying operation controlling element 11 or between the operation controlling element 11 and the overlying magnetically sensitive element 12, although such intervening layers are not shown in Fig. 1. These intervening layers can be formed during thin-film forming process.

In this particular embodiment the magnetically sensitive element 12 is a magnetic element in which a giant Barkhausen Jump phenomenon appears, and the operation controlling element 11 is a permanent magnet. Such magnetically sensitive elements 12 are of an iron-and-nickel alloy, an iron-and-cobalt alloy or an amorphous material, and its structure is a multi-lamination of hard and soft layers or a single layer. When the magnetic element is alternately exposed to the magnetic field of one or the other polarity, the magnetic walls inside are made to shift quickly, causing the reversal of magnetization. Then, an impulsive voltage appears across a nearby pickup coil. The reversal of magnetization is independent from the varying rate of the external magnetic field, but is responsive to the rise of the external magnetic field above a certain critical strength. The reversal of magnetization due to the quick shift of magnetic walls is called the "giant Barkhausen Jump phenomenon".

Such magnetically sensitive elements and operation controlling elements can be provided according to the following film forming processes:
1) sputtering process;
2) vacuum vaporizing process;
3) plating process and
4) CVD process.

As disclosed in Patent Application Laid-Open No.2000-30939 working conditions can be so changed at each step of the film-forming process that the so formed magnetic layers may be different from each other in crystal structure. Specifically the crystal size, directivity, coarseness and other factors may be changed to control the coercive field strength and anisotropy of each magnetic layer in which a giant Barkhausen Jump phenomenon appears.

As for the permanent magnet used as the operation controlling element a film of CoPt may be used other than the ordinary permanent magnet material.

The method of integrally forming the magnetically sensitive element and operation controlling element on the substrate other than those described above may comprise the steps of bonding a magnetically sensitive element and an operation controlling element on each other on the substrate.

Fig.2 schematically shows a magnetically sensitive element with an associated operation controlling element integrated therewith according to the second embodiment of the present invention. It comprises a substrate 20 having the operation controlling element 21 and the magnetically sensitive element 22 both built thereon.

In this particular embodiment the opposite sub-elements of the operation controlling element 21 and the magnetically sensitive element 22 are series-arranged in a straight longitudinal line on the substrate 20. These operation controlling element and magnetically sensitive element 21 and 22 are integrally formed according to the thin film-forming process.

The film-forming process is similar to the one described above in connection with the first embodiment.

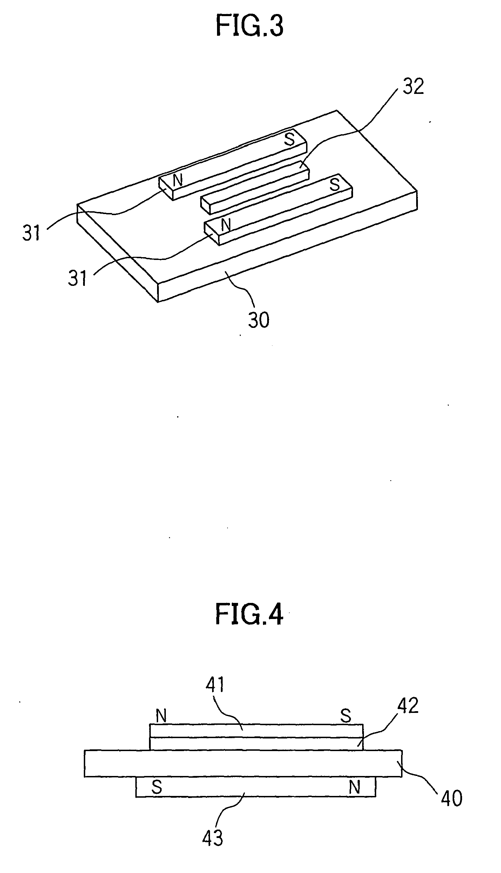

Fig.3 schematically shows a magnetically sensitive element with an associated operation controlling element integrated therewith according to the third embodiment of the present invention. It comprises a substrate 30 having the operation controlling element 31 and the magnetically sensitive element 32 both built thereon.

In this particular embodiment the opposite sub-elements of the operation controlling element 31 and the magnetically sensitive element 32 are parallel-arranged on the substrate 30 with the magnetically sensitive element 32 arranged between the opposite sub-elements. These operation controlling element and magnetically sensitive element 31 and 32 are integrated with each other according to the thin film-forming process.

The film-forming process is similar to the one described above in connection with the first embodiment.

Fig.4 schematically shows a magnetically sensitive element with an associated operation controlling element integrated therewith according to the fourth embodiment of the present invention. The operation controlling element which is integrated with the magnetically sensitive element in the first, second or third embodiment is of a single-layered structure. In contrast, in the fourth embodiment the operation controlling element is of a multi-layered structure. Specifically, a magnetically sensitive element 42 is formed on one surface of the substrate 40, and a layer of first operation controlling element 41 is formed on the underlying magnetically sensitive element 42, and a layer of second operation controlling element 43 is formed on the other surface of the substrate 40. These layers 41, 42 and 43 are formed as a whole according to the thin film-forming process.

The film-forming process is similar to the one described above in connection with the first embodiment.

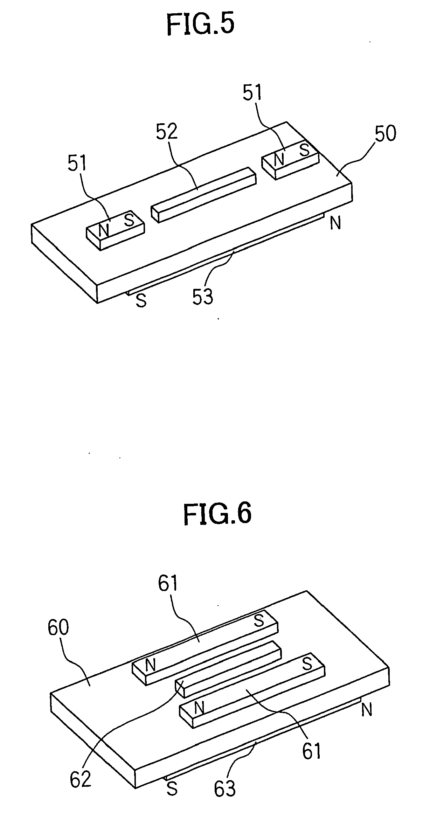

Fig.5 schematically shows a magnetically sensitive element with an associated operation controlling element integrated therewith according to the fifth embodiment of the present invention. Similar to the fourth embodiment, a multi-layered operation controlling element is formed relative to the magnetically sensitive element 52. Specifically two layers of first operation controlling element 51 are formed in line with the magnetically sensitive element 52 on one surface of the substrate 50, and a layer of second operation controlling element 53 is formed on the other surface of the substrate 50. These layers 51, 52 and 53 are formed as a whole according to the thin film-forming process.

The film-forming process is similar to the one described above in connection with the first embodiment.

Fig.6 schematically shows a magnetically sensitive element with an associated operation controlling element integrated therewith according to the sixth embodiment of the present invention. Similar to the fourth embodiment, a multi-layered operation controlling element is formed relative to the magnetically sensitive element. Specifically two opposite layers of first operation controlling element 61 are formed parallel with the magnetically sensitive element 62 on one surface of the substrate 60 with the magnetically sensitive element 62 between the opposite layers of operation controlling element 61, and a layer of second operation controlling element 63 is formed on the other surface of the substrate 60. These layers 61, 62 and 63 are formed as a whole according to the thin film-forming process.

The film-forming process is similar to the one described above in connection with the first embodiment.

As regards the first, second and third embodiments the operation controlling element of one polarity is provided for alternate application of magnetic field to the magnetically sensitive element. As regards the fourth, fifth and sixth embodiments the operation controlling element of the opposite polarities are provided for alternate application of magnetic field. The multi-layered operation controlling element may have two layers formed on the front or rear surface of the substrate, not one layer formed on each surface as in the fourth, fifth and sixth embodiments.

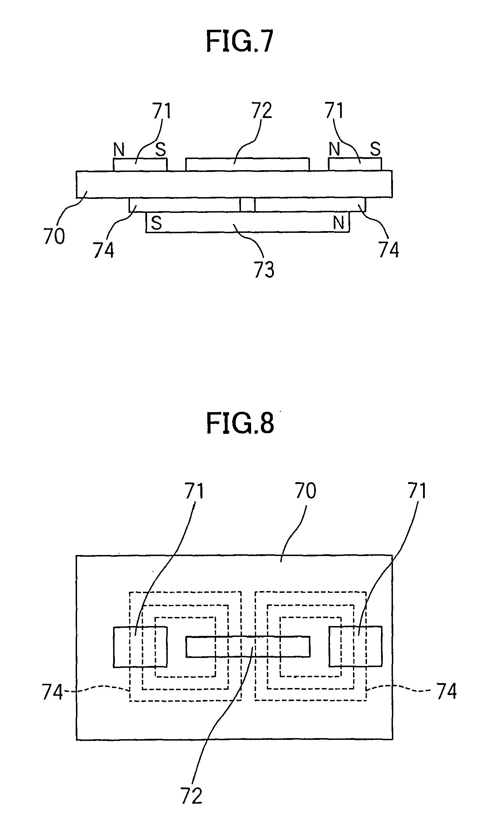

Fig.7 schematically shows a magnetically sensitive element with an associated operation controlling element integrated therewith according to the seventh embodiment of the present invention. Fig.8 is a plane view of the seventh embodiment. Similar to the fourth embodiment, a multi-layered operation controlling element is integrally formed relative to the magnetically sensitive element, and pickup coils are integrally formed, also. Specifically as shown in Figs.7 and 8, two first sub-elements 71 of the operation controlling element and the magnetically sensitive element 72 are aligned in a straight line on one surface of the substrate 70, and the two pickup coils 74 and an overlying second sub-element 73 of the operation controlling element are formed on the other surface of the substrate 70. These layers 71, 72, 73 and 74 are formed as a whole according to the thin film-forming process.

The film-forming process is similar to the one described above in connection with the first embodiment.

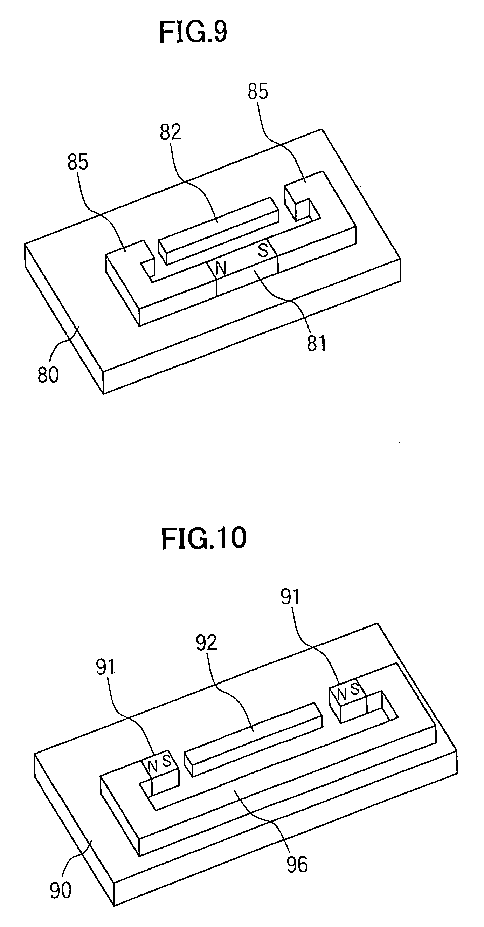

Fig.9 schematically shows a magnetically sensitive element with an associated operation controlling element integrated therewith according to the eighth embodiment of the present invention. As shown, an operation controlling element 81 in the form of permanent magnet and a magnetically sensitive element 82 are parallel-arranged and formed on the substrate 80, and magnetic circuit forming members 85 are so formed that the magnetic flux from the permanent magnet 81 may be led to the magnetically sensitive element 82, thereby allowing the permanent magnet 82 to apply its magnetic field effectively to the magnetically sensitive element 82. The magnetic circuit forming members 85 are included in the operation controlling element 81 as constitutional parts. These elements 81, 82 and 85 are formed as a whole according to the thin film-forming process.

The film-forming process is similar to the one described above in connection with the first embodiment.

Fig. 10 schematically shows a magnetically sensitive element with an associated operation controlling element integrated therewith according to the ninth embodiment of the present invention. As shown, the opposing sub-elements 91 of the operation controlling element in the form of permanent magnet and the magnetically sensitive element 92 are series-arranged and formed on the substrate 90, and a magnetic circuit forming member 96 is formed to allow the sub-elements 91 of the permanent magnet to apply its magnetic field effectively to the magnetically sensitive element 92. The magnetic circuit forming member 96 is included in the operation controlling element as its constitutional part. These elements 91, 92 and 96 are formed as a whole according to the thin film-forming process.

The film-forming process is similar to the one described above in connection with the first embodiment.

In the above described embodiments the magnetically sensitive element is a magnetic element in which a giant Barkhausen Jump phenomenon appears. It should be noted that the present invention is not limited to use of such magnetic element; same effects can be caused by using a Hall element, an MR element (magneto-resistive element), a GMR element (giant magneto resistance element) or a TMR element (tunneling magnetoresistive element). Also, in the above described embodiments a permanent magnet is used as an operation controlling element, but an electromagnet can be used instead.

### Industrial Utility

Integration of a magnetically sensitive element and an associated operation controlling element into a single chip provides advantages as follows: such integrated magnetic sensitive devices can be easily handled; the degree of freedom is increased in designing a machine or apparatus having a magnetic sensitive device built therein; reduction both in size and manufacturing cost is attained thanks to reduction of parts in number; the production line can be less complex, significantly benefiting the mass production.

The magnetic field can be confined in the single chip, and the magnetically sensitive element is insensitive to external magnetic field if any, and still advantageously the products can have same qualities or characteristics.

Particularly magnetic elements in which a giant Barkhausen Jump phenomenon appears and an associated operation controlling element can be strictly adjusted to assure the equilibrium in magnetic strength.

## Claims

1. A magnetically sensitive element **characterized in that** it is integrated with an operation controlling element.

2. A magnetically sensitive element according to claim 1 wherein the magnetically sensitive element and the operation controlling element are integrally connected according to the film-forming process.

3. A magnetically sensitive element according to claim 1 wherein the magnetically sensitive element and the operation controlling element are integrally connected by sticking pieces of films or thin layers on each other.

4. A magnetically sensitive element according to claim 1, 2 or 3 wherein the operation controlling element is given in the form of a single layer.

5. A magnetically sensitive element according to claim 1, 2 or 3 wherein the operation controlling element is given in the form of plural layers.

6. A magnetically sensitive element according to claim 1, 2, 3, 4 or 5 wherein the operation controlling element comprises a permanent magnet.

7. A magnetically sensitive element according to claim 1, 2, 3, 4 or 5 wherein the operation controlling element comprises an electromagnet.

8. A magnetically sensitive element according to claim 6 or 7 wherein the operation controlling element includes a magnetic circuit forming member.

9. A magnetically sensitive element according to any of claims 1 to 8 wherein the magnetically sensitive element is a magnetic element in which a giant Barkhausen Jump phenomenon appears.

10. A magnetically sensitive element according to any of claims 1 to 9 wherein the magnetically sensitive element is integrated with a pickup coil or coils.
